(19) Europäisches Patentamt
European Patent Office
Office européen des brevets

(11) **EP 2 117 115 B1**

(12) **EUROPEAN PATENT SPECIFICATION**

(45) Date of publication and mention
of the grant of the patent:
**30.11.2011 Bulletin 2011/48**

(51) Int Cl.:
***H03F 1/32*** *(2006.01)*

(21) Application number: **08425312.9**

(22) Date of filing: **06.05.2008**

(54) **Improvement to remote control methods of transmission signals adaptive predistortion**

Verbesserung am Fernsteuerungsverfahren der adaptiven Vorverzerrung von Übertragungssignalen

Amélioration des procédés de contrôle à distance de pré-distorsion adaptative de signaux de transmission

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**11.11.2009 Bulletin 2009/46**

(73) Proprietors:
• **Nokia Siemens Networks S.p.A.**
  **20126 Milano (IT)**
• **Nokia Siemens Networks OY**
  **02610 Espoo (FI)**

(72) Inventors:
• **Colombo, Robert**
  **20081 Abbiategrasso (IT)**

• **Di Donna, Giambattista**
  **20064 Gorgonzola (IT)**
• **Segala, Simone**
  **20052 Monza (IT)**

(74) Representative: **Fischer, Michael**
**Nokia Siemens Networks GmbH & Co. KG**
**Intellectual Property Rights**
**P.O. Box 80 17 60**
**81617 München (DE)**

(56) References cited:
**EP-A- 1 280 272       EP-A- 1 499 012**
**US-A1- 2007 153 884**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**FIELD OF THE INVENTION**

The present invention relates to the field of radio links using linearly modulated carriers, like M-QAM, OFDM, etc., and more precisely to an improvement to remote control methods of transmission signals adaptive predistortion (acronym list is reported at the end of the description).

**BACKGROUND ART**

Modern telecommunication networks either point-to-point like the line-of-sight radio links or point-to-multipoint like UMTS, GPRS, WiMAX, etc., generally implement linear modulation techniques to more efficiently exploit the available bandwidth. These modulations at the highest levels of the transmission signal are adversely affected by the characteristic saturation of high power transmission amplifiers. A predistorter is a non-linear device placed upstream the high power amplifier (HPA) in order to reverse the input-output characteristic of the HPA over a proper frequency range. If the predistortion characteristic adequately matches the distortion of HPA, the most part of the side effects of saturation are prevented as well as in band intermodulation noise

The HPA linearization technique received great attention in the last thirty years, starting with analog not adaptive (static) predistortion devices operating at IF or RF level. Today they are considered obsolete for the prohibitive cost and poor performances attained. A historical article of A. M. Saleh published in November 1981 gave an analytical description of the TWT power amplifier. This work will became a test bench for all linearization techniques proposed in the technical literature thereafter. A. M. Saleh also described the first adaptive predistortion algorithm operating on the signal constellation of I-Q modulated signals. A series of papers from G. Karam and H. Sari appeared in the literature at the beginning of 1990, offering several approaches to the predistortion. They first gave a criterion to evaluate the performance of a linearization technique based on the net gain coming from OBO (Output Back-Off) reduction at the HPA transmitter, and the S/N increasing for a fixed BER at the receiver. This criterion is considered incomplete because it does not mention the spectrum broadening in the transmitted signal due to inter-modulation contributes, which often overflows the emission masks foreseen by relevant standards.

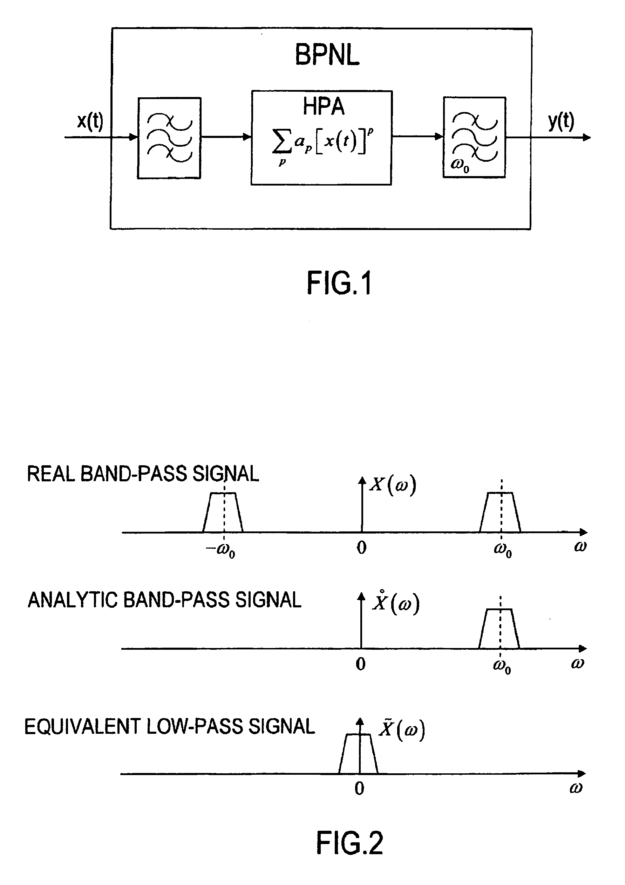

Nowadays adaptive digital predistorters (ADPD) are almost exclusively used in the transmitters. They consist of a circuitry accounting for In-phase and In-quadrature (I-Q) baseband signal components at the modulator stage, while the HPA is a bandpass analog RF stage as in **fig.1** With reference to the figure, we see a bandpass non-linear stage BPNL constituted by a high power amplifier HPA and two bandpass filters placed at the input, for an input signal $x(t)$, and at the output for an output signal $y(t)$, respectively.

With reference to **fig.2**, a common mathematical background is needed to understand the reciprocal interaction between a baseband predistorter and a passband HPA. It is largely known from signal theory that any narrowband real signal $x(t)$ (having the symmetrical spectra visible at the top of the figure) can be reconstructed by the only knowledge of the spectrum with positive frequencies (the analytic representation at the centre part of the figure). The analytic signal in time domain can be written in the form: $\dot{x}(t) = \tilde{x}(t)e^{j\omega_0 t}$, where $\omega_o = 2\pi f_o$ is the pulsation of RF carrier, and $\tilde{x}(t)$ (generally complex) is a baseband signal called the "complex envelope" or "equivalent low-pass signal" associated with the real signal $x(t)$. The spectrum of $\tilde{x}(t)$ is represented in the bottom part of the figure.

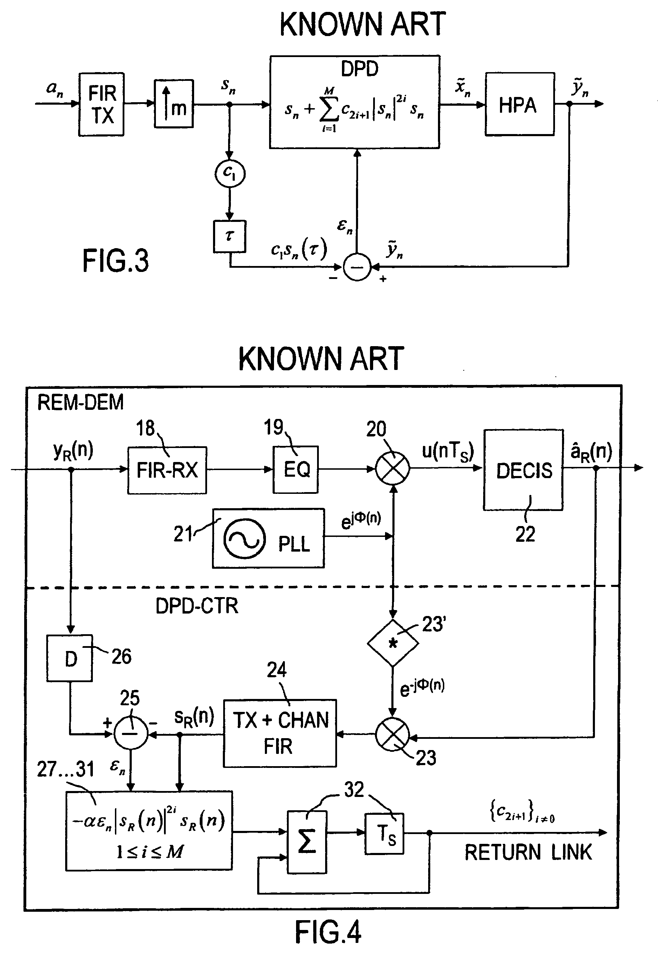

An adaptive digital predistortion structure based on Volterra's memoryless series is described in the article of G. Lazzarin and S. Pupolin, titled: "Nonlinearity compensation in digital radio systems", published on IEEE Transactions on Communications - Vol. 42, No 2/3/4, February/March/April 1994. A plot of the spectrum at the output of HPA completes the evaluation criteria. This ADPD structure is represented in **fig.3**, where each signal is a complex envelope considered at the sampling instants $n$, that is in a common low-pass framework. With reference to **fig.3**, the baseband transmitting structure includes a digital transmission filter of finite-impulse-response FIR TX for an input sequence of samples of symbols $a_n$, followed by an up-sampling stage ↑m for obtaining an oversampled signal $s_n$ at the input of a digital predistorter DPD, which generates a predistortion signal $\tilde{x}_n$ at the input of the HPA. Signal $s_n$ is split in another copy directed to the input of a multiplication and delaying stage for obtaining a comparison signal $c_1 s_n(\tau)$ reaching the subtraction input (-) of a digital subtractor, whose other input (+) is reached by signal $\tilde{y}_n$ fed back from the output of TX amplifier HPA. An error signal $\varepsilon_n$ at the output of the subtractor is directed to the predistorter DPD for updating the coefficients $c_i$ of the following polynomial expansion accounting for compensating the distortion:

$$\tilde{x}_n = \tilde{s}_n + \sum_{i=1}^{M} c_{2i+1} \left|\tilde{s}_n\right|^{2i} \tilde{s}_n = \tilde{s}_n + c_3 \left|\tilde{s}_n\right|^2 \tilde{s}_n + c_5 \left|\tilde{s}_n\right|^4 \tilde{s}_n + \dots\dots, \qquad (1)$$

where the first term is the linear component, the second one is the third harmonic contribute, the third term is the fifth harmonic, and so on. The only odd harmonic terms are present (the ones giving in-band contributions to cancel the distortion) as per two-tones measurement of distortion which generalizes the sinusoidal inter-modulation behaviour of HPA. Expression (1) coincides with well known memoryless Volterra's series, as described for example in the volume of S. Benedetto, E. Biglieri and V. Castellani, "Digital Transmission Theory". Englewood Cliffs, NJ; Prentice-Hall, 1987.

Many other papers followed in technical literature addressing adaptive predistortion, but the adaptive criterion remained always the same as in the G. Lazzarin and S. Pupolin article, to say, the coefficients of DPD are updated by the comparison of a distorted signal at the output of HPA with a linearly modulated signal available at the predistorter output. The main drawback of this approach is that a complete receiver is needed at the transmitter side, rendering it too expensive for a point-to-point radio system.

European patent EP 1280272 B1 (priority 27.07.2001) discloses a linearization method and relative system developed in the Applicant's laboratories for removing the drawback highlighted above. Hereafter EP 1280272 B1, will be considered the nearest prior art the present invention is aimed to improve. **Fig.4**, with the same labels used in fig.2 of the citation, shows the only baseband section of a remote demodulator REM-DEM therein disclosed. Complex signals with In-phase and In-quadrature (I-Q) components are used and also the coefficients are complex numbers, so the various blocks carry out mathematical operations on complex numbers.

With reference to **fig.4**, the reception baseband digital signal $y_R(n)$ enters a numeric digital filter (FIR RX) 18, whose output signal crosses an equalizer (EQ) 19 and reaches a complex multiplier 20 (phase-rotator) to be multiplied by a synchronization signal $e^{j\phi(n)}$ coming from a PLL 21, recovering in this way both frequency and phase synchronization with the transmission carrier. The $u(nT_s)$ synchronized signal is transferred to a decision block 22 that provides an estimated sequence $\hat{a}_R(n)$ of transmitted symbols. Up to now the well-known receiver structure has been described. Next part DPD-CTR of remote demodulator REM-DEM controls a digital predistorter (not shown) included in the transmitter. This circuitry appears very complicated at glance. The reason is that the reception signal $y_R(n)$, affected by residual distortion and noise, is used as comparison signal to obtain an error $\varepsilon_n$ for updating the predistortion coefficients $\{c_{2i+1}\}_{i \neq 0}$ fed back on the return link. Complication arises because a linear (undistorted) counterpart $s_R(n)$ of $y_R(n)$ must be reconstructed in order to the comparison is correct. Reconstruction involves a phase de-rotation (23' and 23) of $\hat{a}_R(n)$ decided symbols and filtration by a FIR (TX + CHAN) 24 which equals the channel plus TX filter transfer function and whose coefficients need to be estimated at the receiver side Besides, $Y_R(n)$ shall be opportunely delayed by a delay stage 26 (D). The error signal at the output of digital subtractor 25 is:

$$\varepsilon_n = y_R(n) - s_R(n) \ . \tag{2}$$

The remaining blocks 27 to 32 iteratively calculate the following adaptation expression:

$$c_{2i+1}(n+1) = c_{2i+1}(n) - \alpha \varepsilon_n \left| s_R(n) \right|^{2i} \overset{*}{s}_R(n), \text{ for } 1 \le i \le M \text{ and } c_{2i+1}(0) = 0 \ . \tag{3}$$

Upon reception of coefficients $c_{2i+1}$, the predistorter calculates the Volterra polynomial expansion, without memory (1), with odd terms, truncated at the fifth order term, that approximately reverses the HPA distortion. In general, predistortion terms higher than the fifth do not contribute in a significant way to improve linearization. The invention disclosed in EP 1280272 B1 easily overcame the drawbacks of the inventions described in WO 98/28888 and US 5910965 A1, both of them also concerned in the remote detection of non-linearity information, returned to the transmitter for updating the degree of predistortion. In spite of its merits, the updating of predistortion coefficients according to the method of EP 1280272 B1 is still too complicated, this because the implementation of aforementioned FIR (24) is a problematic task that requires iterative adjustment of filter coefficients. Besides, residual noise and ISI negatively affect the error signal (2).

## SUMMARY OF THE INVENTION

In view of the state of the art described, it is an object of the present invention to provide a simplified, cheaper, and more reliable method for remotely controlling the adaptation of Volterra's series terms used for reversing the non-linearity of HPAs.

The invention achieves said object through a method for compensating signal distortion generated by a distorting radiofrequency power amplifier in a transmitter connected to a remote receiver, the method including the steps of:

- predistorting a linearly modulated transmission signal before it crosses said distorting amplifier according to a predistortion function approximated by a truncated polynomial Volterra's series of said transmission signal;
- generating by the receiver a control signal of predistortion function from an error of residual distortion calculated by subtracting an estimate of information symbols transmitted from the reception signal after being subjected to: filtering, equalization, and both symbol and carrier synchronization recovery;
- transmitting by the receiver said control signal back to the transmitter;
- receiving at the transmitter said control signal and using it for updating odd terms of the Volterra's series, as described in claim 1.

According to the method of the invention, predistortion is preceded by up-sampling the information symbols by a multiple of symbol rate nearly equal to the maximum order of the last term in said truncated Volterra's series. Up-sampling by a factor four is enough. The reception signal is down-sampled accordingly.

The error of residual distortion $\varepsilon_n$ is calculated by the following expression:

$$\varepsilon_n = u\left(nT_s\right) - \hat{a}_n,$$

where: (4)

- $nT_s$ is the $n^{th}$ symbol interval of duration $T_s$,
- $u(nT_s)$ is the baseband reception signal after being subjected to: filtering, equalization, and both symbol and carrier synchronization recovery,
- $\hat{a}_n$ is the estimate of information symbol transmitted at instant $nT_s$.

Further object of the invention is a system for compensating signal distortion, operating according to the method of claim 1.

Additional features of the invention are described in depended claims.

According to an embodiment of the invention, said control signal returned to the transmitter coincides with coefficients $c_{2i+1}$ of odd predistortion terms of Volterra's series, updated by the following expression:

$$c_{2i+1}\left(n+1\right) = c_{2i+1}\left(n\right) - \alpha\varepsilon_n\left|\hat{a}_n\right|^{2i}\hat{a}_n^{\bullet}, \qquad (5)$$

for $1 \leq i \leq M$ and $c_{2i+1}\left(0\right) = 0$, where:

- $n$ is the $n^{th}$ updating interval,
- $\alpha$ is a predetermined numerical factor (step-size) which controls the speed of coefficient updating, and the asterisk denotes the complex conjugated.

Without limitation, $M = 2$ is considered enough, and the right algebraic signs of coefficients $c_{2i+1}$ being set by the feed back scheme itself, automatically. The updating interval n spans a predetermined number of symbol intervals $T_s$ in order to avoid an useless overload on return link. At least 1,000 symbol intervals are recommended. In this case expression (5) behaves as a running average spanning the whole updating interval. Upon reception of new complex coefficients $c_{2i+1}$ at the transmitter, the corresponding odd terms of Volterra's series (1) are updated accordingly, that is new coefficients replace the old ones in the Volterra's series (1).

According to an alternative embodiment of the invention, the control signal returned to the transmitter includes the only algebraic signs of coefficient increments $\Delta c_{2i+1}$, averaged on a predetermined number of symbol intervals $T_s$. Upon reception of new algebraic signs at the transmitter, the complex coefficients $c_{2i+1}$ of corresponding odd terms of the Volterra's series (1) are updated accordingly.

**ADVANTAGES OF THE INVENTION**

The great simplification achieved in the predistorter control part inside the remote demodulator is clearly evident comparing the error expression (2) with (4). The proposed idea of solution consists of using the "as suitable as possible" reception signal as element of comparison to determine the error $\varepsilon_n$. In fact, both I-Q components of $u(nT_s)$ signal are the nearest ones to decided symbol $\hat{a}_n$, just because the $u(nT_s)$ signal has been preventively: optimally filtered, equalized, and time aligned to the transmission carrier. With that, differently from the scheme of **fig.4**, the reconstruction of a linear counterpart ($s_R(n)$), as second term of comparison to determine $\varepsilon_n$, is entirely avoided. As a consequence, the delay stage (D) of first comparison term ($y_R(n)$) is also avoided.

The advantages of the highlighted simplified updating algorithm reflects in a cheaper adaptation control part, because both signals $\hat{a}_n$ and $\varepsilon_n$ are already available in any demodulator, so allowing the implementation of the control algorithm of predistorter into the same chip which implements the whole functionalities of the modem.

Moreover the system for compensating signal distortion, also object of the present invention, is quite insensitive to the channel impairments, as AWGN and selective fading, considering that signals $\varepsilon_n$ and $\hat{a}_n$ it elaborates are after the RX filter and the baseband equalizer.

Finally, the alternative embodiment allows of saving much bandwidth on the return channel.

## BRIEF DESCRIPTION OF THE DRAWINGS.

The features of the present invention which are considered to be novel are set forth with particularity in the appended claims. The invention and its advantages may be understood with reference to the following detailed description of an embodiment thereof taken in conjunction with the accompanying drawings given for purely non-limiting explanatory purposes and wherein:

- **fig.1** shows a mathematical model for bandpass HPA;
- **fig.2** shows usual spectral representations of a narrowband real signal;
- **fig.3** shows the structure of a transmitter configured for updating the coefficients of predistortion terms of Volterra's series according to old prior art;
- **fig.4** shows a demodulator of the nearest prior art embedding a control circuitry for remotely updating the coefficients of predistortion terms of Volterra's series;
- **fig.5** shows a transmission chain embedding a predistortion control circuitry at the remote demodulator, simplified according to the teaching of the present invention;
- **fig.6** shows a test bench for evaluating the performances of a microwave transmitter joined to an evaluation board including the simplified control circuitry of fig.5;
- **fig.7** shows comparative spectra displayed on the screen of a spectrum analyzer belonging to test bench of fig.6.

## DETAILED DESCRIPTION OF PREFERRED EMBODIMENTS OF THE INVENTION

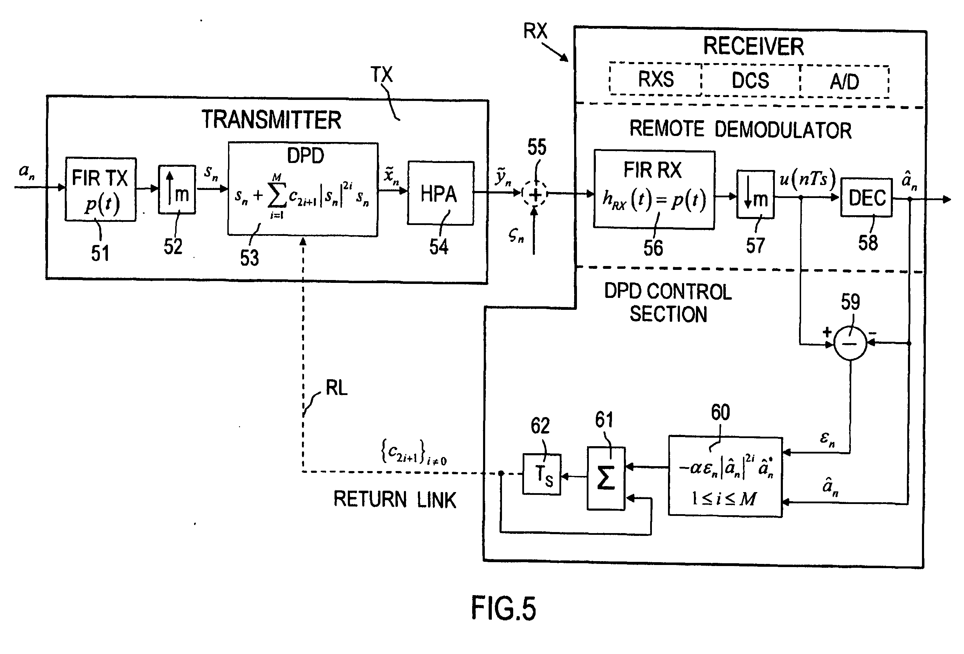

**Fig.5** shows a radio communication system constituted by a microwave transmitter TX connected to a receiver RX through a direct link 55 and a reverse link RL (return channel). To the sake of simplicity the sole baseband signals and relevant functional blocks are indicated (with exception of HPA all blocks deal with digital signals). Following the block diagram of **fig.5** form left to right, $a_n$ indicates a sequence of complex information symbols at the input of the transmitter, which enter a pulse shaping filter 51 (FIR TX) of root raised cosine type p(t) with predetermined roll-off (e.g. 0.15). The filtered signal reaches an interpolation stage 52 to be up-sampled in respect of the symbol interval $T_s$ of a factor $m$ yielding a signal $s_n$ at the input of a digital predistorter (DPD) 53. The latter is implemented in Volterra's series form (1), where the only odd terms up to the fifth order need of being controlled by updating respective complex coefficients $c_{2i+1}$. To this aim the predistorter 53 has an input for a control signal coming from the receiver RX. Up-sampling the transmitted signal $s_n$ by a factor $m = 4$ is enough to broaden the original bandwidth up to four time the symbol rate, so as to let pass unaffected the third and fifth harmonic of predistorted signal $x_n$ at the output of predistorter 53. Signal $x_n$ is digital-to-analog converted, translated to RF and amplified by a microwave power amplifier 54 (HPA) driven up to enter its gain saturation region. The intrinsic distortion of HPA is compensated by the upstream predistortion, so the RF transmitted signal $\tilde{y}_n$ is in such a way undistorted. This signal reaches the remote receiver RX through a radio channel 55, affected by AWGN noise and interference. Digital remote demodulator is shown in foreground inside the receiver RX, while some dashed blocks indicate in the order: radiofrequency receiving section (RXS), frequency down converting section (DCS), and analog to digital conversion section (A/D). Digital baseband reception signal crosses a receiving filter 56 (FIR RX) upstream a down-sampling stage 57, in order to remove all inter-symbol interference (ISI) and reinstate the original rate with one sample for symbol period $T_s$, allowing a correct estimate of the information symbol transmitted. FIR 56 is an "optimum filter" of received signal. Symbol and carrier synchronization recovery as well as baseband equalization are implicitly assumed and hence not indicated in the generation of a final signal $u(nT_s)$ entering a decision stage 58 (DEC) which provides estimates $\hat{a}_n$ of the transmitted information symbols $a_n$. The following operations: baseband "optimum" filtration, equalization, symbol and carrier synchronization recovery, so as subsequent symbol estimation, make use of well known algorithms widely illustrated in a lot of technical articles and books in the field of digital communications, for example, the old volume (1987) of S. Benedetto, E. Biglieri and V. Castellani, or the volume of John G. Proakis, "Digital Communications", fourth edition 2001, McGraw-Hill, ISBN 0-07-232111-3. In these books particular attention is directed to the estimate (decision) of information symbols transmitted, which depends on the particular multiplexing strategies used by the transmitter, e.g. OFDM, CDMA, TDMA, FDMA, etc. The known estimation techniques are sub-divisible in two categories according to the decision is taken symbol-by-symbol or on the basis of a sequence of symbols transmitted (e.g. MLSE suitable to use the Viterbi's algorithm). Independently of the estimation strategy adopted in the receiver, the estimator/decider device shall have stored the numerical values of I-Q components of each symbol belonging to the modulation alphabet. On this basis, a measures of distance between the received signals and the stored symbols feed the decisional metric adopted. Without limitation, symbol-by-symbol decision is performed in the decider 58.

The remote demodulator includes a control section of predistorter DPD 53; this section includes a digital subtractor 59 receiving the signal $u(nT_s)$ at its minuend input (+) and the estimates $\hat{a}_n$ at the subtrahend input (-) and providing a complex error signal $\varepsilon_n = u(nT_s) - \hat{a}_n$ at its output. The error $\varepsilon_n$ and the estimates $\hat{a}_n$ are forwarded to respective inputs of an accumulation chain including blocks 60, 61, and 62 for updating the predistortion coefficients $\{c_{2i+1}\}_{i\neq 0}$ Block 60 calculates the following coefficient increments: $-\alpha\varepsilon_n\left|\hat{a}_n\right|^{2i}\hat{a}_n^*(n)$ included in the expression (5); while blocks 61 and 62 accumulate said increments at symbol interval $T_s$ to obtain updated coefficients $\{c_{2i+1}\}_{i\neq 0}$ sent back on the return link RL at every updating interval $n$, in their real and imaginary component parts, towards the predistorter 53. Upon the reception of coefficients $\{c_{2i+1}\}_{i\neq 0}$, the predistorter 53 replaces the old coefficients $c_{2i+1}$ with the new ones, as indicated in the expression (1).

Simulation investigations have shown that the predistorter performances do not appreciably improve if harmonic terms other than the fifth one are present, so $M = 2$ is the right choice. The updating interval should be at least 1,000 symbol intervals $T_s$, to avoid an useless overload of the channel on the return link RL.

A pragmatic shrewdness concerns the way the coefficients of DPD 53 can be sent on the return link RL. It could be useful moving the functionality of complex accumulator in the predistorter 53 at the transmitter TX. In this eventuality, complex coefficients $c_{2i+1}$ are updated inside the transmitter upon reception of a simplified updating information. To this end, the control signals of the coefficients $c_{2i+1}$ are averaged for a predetermined time period depending on symbol interval $T_s$, for example about 1 ms, separately for real and imaginary part, and then the only algebraic signs are fed back, saving much service capacity on the return channel. In other hands, the expression (5) becomes:

$$c_{2i+1}(n+1) = c_{2i+1}(n) - \alpha \cdot sign\left[\left\langle \varepsilon_n \left|\hat{a}_n\right|^{2i}\hat{a}_n^* \right\rangle\right], \qquad (6)$$

where the angle brackets $\langle...\rangle$ indicate the time average of the signal inside. Now expression (6) becomes:

$$c_{2i+1}(n+1) = c_{2i+1}(n) - \alpha\left(algebraic\ received\ sign\right), \qquad (6')$$

and is performed at the transmitter side, so the return link burden is reduced at the only bits of algebraic signs.

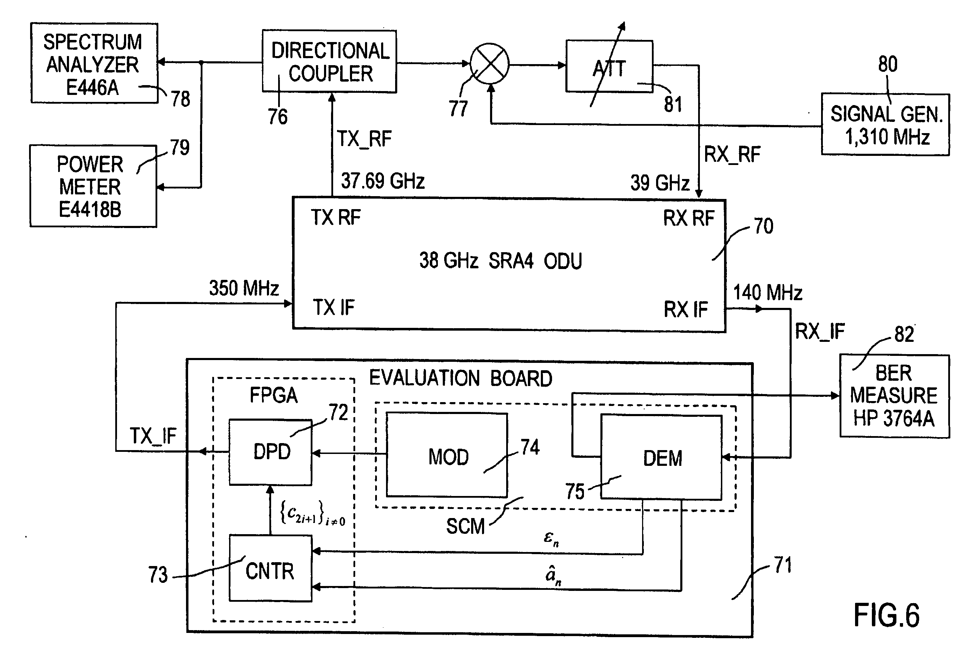

To experimentally evaluate the performances of adaptive predistorter (53 in fig.5) and its control section (fig. 5, elements 59 to 62), a test bench has been designed ad hoc. In the test bench of **fig.6** a commercial "38 GHz SRA4 ODU" apparatus 70 is connected to an evaluation board 71, and some external instruments. The evaluation board 71 includes the innovative predistorter 72 (DPD) and the relative control section 73 (CNTR) both implemented in FPGA, closely working with the already existing single-chip modem (SCM) implemented with ASIC. DPD 72 and CNTR 73 correspond to DPD 53 (fig.5) and DPD Control Section 59 to 62 (fig.5), respectively. Modem SCM includes a digital modulator 74 (MOD) and a digital demodulator 75 (DEM), jointly performing all described mo-demodulations and control functionalities. Different commercial radio equipments (SRA4 ODU) developed in the Applicant's firm for SDH radio systems working in different frequency bands included in the range from 7 GHz up to 38 GHz, have been tested in the same manner.

With reference to fig.6, at the output of DPD 72 with TX_IF is indicated a 350 MHz intermediate frequency transmission signal forwarded to a TX IF input of ODU 70, also called DUT (Device Under Test). Signal TX_IF is up-converted to 37.69 GHz and power amplified by a distorting HPA to be outputted at an output TX RF as TX_RF transmission signal. This signal reaches a directional coupler 76, where is split in three components respectively directed to a mixer 77, a commercial spectrum analyzer 78 (E446A), and a power meter 79 (E4418B). An external signal generator 80 generates a reference sinusoidal signal at 1,310 MHz applied to the pump input of mixer 77. An image filter (not shown) cascaded to the mixer 77 selects the upper sideband at 39 GHz as RX_RF reception signal. This signal, opportunely attenuated through a variable attenuator 81, is applied to a RX RF radiofrequency input of DUT 70. Signal RX_RF is down converted to a different intermediate frequency RX_IF of 140 MHz and outputted at a corresponding RX IF output of DUT 70 towards the input of DEM 75. The latter estimates information symbols transmitted $\hat{\alpha}_n$ and calculates the error $\varepsilon_n$, both directed to the control section 73 (CNTR). Besides it forwards the demodulated signal to an external BER measurement instrument 82 (HP 3764A). Control section 73 (CNTR) performs coefficient updating according to expression (5) and sends them ($c_{2i+1}$) to predistorter 72, so the loop is closed.

The speed of coefficient convergence toward their steady state values, has been evaluated by simulations and experimental implementations, which confirms that it is enough for avoiding bad interactions with typical system functionalities, like ATPC up to 100 dB/s and AMC (Adaptive Modulation Coding).

It is worthwhile to point out that the bandwidth from the DPD up to the HPA input must be large enough to pass unaffected the third and fifth harmonic components of the predistorted signal. Simulations results show that a 3 dB flatness is required in the band of $F_0 \pm 2F_S$, where $F_0$ is the central RF frequency and $F_S$ is the symbol rate.

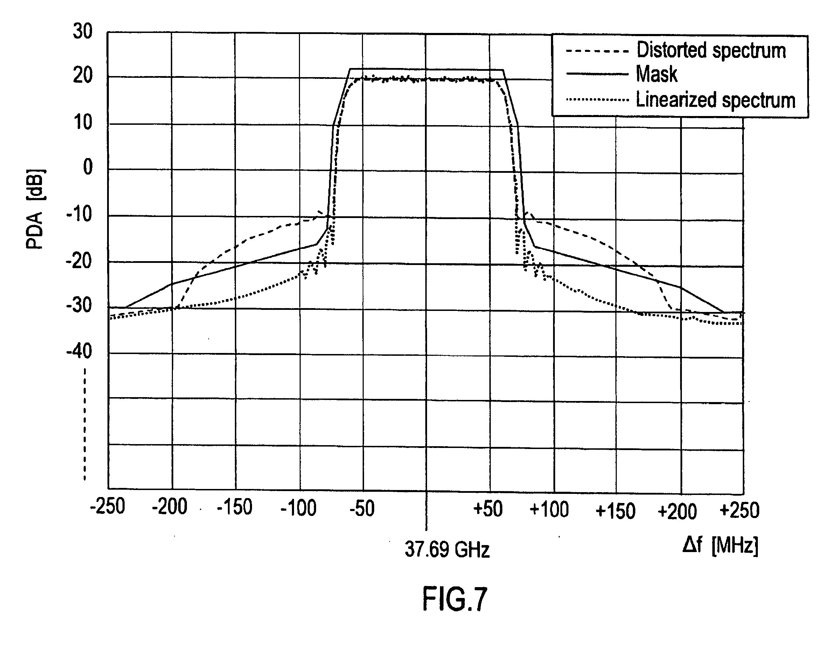

**Fig.7** shows the transmission spectra around 37.69 GHz (with and without predistorter) referred to a 128 QAM, 12 Msymb/s test signal through a root raised cosine pulse-shaping filter with 0.15 roll-off. The actual RF power at the transmitter output is 20 dBm (OBO = 6 dB), while commercial ODUs without predistortion in SDH radio systems work with nominal power of 14 dBm (OBO = 12 dB). Then a net 6 dB power gain has been achieved. The output back-off (OBO) is a parameter defined as the difference in dB between the average RF power transmitted and the maximum power at the HPA output before saturation.

**ACRONYMS**

| | |
|---|---|
| ADPD | Adaptive Digital Predistorters |
| AMC | Adaptive Modulation Coding |
| ASIC | Application Specific Integrated Circuit |
| ATPC | Automatic Transmitter Power Control |
| AWGN | Additive White Gaussian Noise |
| BER | Bit Error Rate |
| BPNL | Bandpass Non-Linear |
| CDMA | Code Division Multiple Access |
| DUT | Device Under Test |
| FDMA | Frequency Division Multiple Access |
| FIR | Finite Impulse Response |
| FPGA | Field Programmable Gate Arrays |
| GPRS | General Packet Radio Service |
| HPA | High Power Amplifier |
| ISI | Intersymbol Interference |
| MLSE | Maximum Likelihood Sequence Estimation |
| M-QAM | Quadrature Amplitude Modulation |
| OBO | Output Back-Off |
| ODU | Outdoor Unit |
| OFDM | Orthogonal Frequency Division Multiplexing |
| PLL | Phase-Locked Loop |
| SCM | Single-Chip Modem |
| SDH | Synchronous Digital Hierarchy |
| TDMA | Time Division Multiple Access |
| TWT | Travelling Wave Tube |
| UMTS | Universal Mobile Telecommunication System |
| HPA | High Power Amplifiers |
| WiMAX | Worldwide Interoperability for Microwave Access |

**Claims**

1. Method for compensating signal distortion generated by a distorting radiofrequency power amplifier (54) in a transmitter (TX) connected to a remote receiver (RX), the method including the steps of:

- predistorting (53) a linearly modulated transmission signal ($s_n$) before it crosses said distorting amplifier (54) according to a predistortion function approximated by a truncated polynomial Volterra's series of said transmission signal;

- generating by the receiver (RX) a predistortion control signal $\left(\left\{c_{2i+1}\right\}_{i\neq 0}\right)$ from the calculation of an error of residual distortion ($\varepsilon_n$) function of an estimate of information symbols transmitted ($\hat{a}_n$).
- transmitting by the receiver (RX) said predistortion control signal back to the transmitter (TX);
- receiving at the transmitter (TX) said predistortion control signal and using it for updating (53) the odd terms of the polynomial Volterra's series,

**characterized in that:**

- said error of residual distortion ($\varepsilon_n$) is calculated by subtracting, said estimate. ($\hat{a}_n$) from the baseband reception signal ($u(nT_s)$) received in the receiver after being subjected to: filtering (56), equalization, and both symbol and carrier synchronization recovery.

2. The method of claim 1, **characterized in that** said predistortion step (53) is preceded by up-sampling (52) said transmission signal by a multiple of symbol rate nearly equal to the maximum order of the last term in said truncated Volterra's series.

3. The method of claim 2, **characterized in that** said reception signal is down-sampled (57) to symbol rate.

4. The method of claim any claim from 1 to 3, **characterized in that** the updating interval of predistortion function spans a predetermined number of symbol intervals.

5. The method of any claim from 1 or 4, **characterized in that** said control signal returned to the transmitter includes the complex coefficients $\left(\left\{c_{2i+1}\right\}_{i\neq 0}\right)$ of odd predistortion terms of Volterra's series updated by the following expression:

$$c_{2i+1}\left(n+1\right) = c_{2i+1}\left(n\right) - \alpha\varepsilon_n \left|\hat{a}_n\right|^{2i} \hat{a}_n^*,$$

for $1 \leq i \leq M$ and $c_{2i+1}(0) = 0$, where:

- $c_{2i+1}(n+1)$ are the updated coefficients $c_i$ at the $n^{th} + 1$ updating interval,
- $\varepsilon_n$ is said error of residual distortion,
- $\alpha$ is a predetermined numerical factor acting on the convergence speed of coefficient updating,
- $\hat{a}_n$ is the estimate of information symbol transmitted at symbol interval $nT_s$, and the asterisk denotes complex conjugated.

6. The method of any claim from 1 to 5, **characterized in that** said error of residual distortion ($\varepsilon_n$) is calculated by the following expression:

$$\varepsilon_n = u\left(nT_s\right) - \hat{a}_n,$$

where:

- $\varepsilon_n$ is said error of residual distortion calculated at $n^{th}$ symbol interval $T_s$,
- $u(nT_s)$ is the reception signal after being subjected to: filtering, equalization, and both symbol and carrier synchronization recovery.;
- $\hat{a}_n$ is the estimate of information symbol transmitted at instant $nT_s$.

7. The method of claim 1, **characterized in that** said control signal returned to the transmitter (TX) includes the only algebraic signs of complex coefficient increments of odd predistortion terms of Volterra's series, averaged on a predetermined time period depending on symbol interval ($T_s$).

8. The method of claim 7, **characterized in that** the transmitter (TX) upon reception of said algebraic signs updates the corresponding complex coefficients by means of the following expression:

$$c_{2i+1}(n+1) = c_{2i+1}(n) - \alpha\left(algebraic\ received\ sign\right),$$

where

- $c_{2i+1}(n+1)$ are the updated coefficients $c_i$ at the $n^{th} + 1$ updating interval, and
- $\alpha$ is a predetermined numerical factor acting on the convergence speed of coefficient updating.

9. The method of any claim from 1 to 8, **characterized in that** said updated terms of polynomial Volterra's series are the only third and fifth ones.

10. System for compensating the signal distortion generated by a Distorting radiofrequency power amplifier (54) in a transmitter (TX) connected to a remote
receiver (RX), further including:

the transmitter further including:

- predistorting means (53) responsive to a predistortion control signal ($\{c_{2i+1}\}_{i \neq 0}$) for updating a pre-distortion function counteracting the distortions introduced on the transmission signal by said downstream connected distorting amplifier (54);
- means for receiving said predistortion control signal on a reverse channel (RL)

the receiver including:

- processing means programmed for filtering (56) and equalizing the reception signal and recovering both symbol and transmission carrier synchronizations;
- means (58) for estimating information symbols transmitted ($\hat{a}_n$) from the Baseband reception signal; received in the receiver
- means (59, 60, 61, 62) for generating said predistortion control signal from the calculation of an error of residual distortion ($\varepsilon_n$) function of the estimate ($\hat{a}_n$) of information signals transmitted;
- means (RL) for transmitting said predistortion control signal on a reverse channel (RL); between said receiver and transmitter

**characterized in that**:

- said means for generating the predistortion control signal are configured to calculate the error of residual distortion ($\varepsilon_n$) by subtracting said estimate ($\hat{a}_n$) from the baseband reception signal ($u(nT_s)$) after being processed by said digital processing means.

11. The system of claim 10, **characterized in that** said predistorting means (53) are configured to predistort the transmission signal ($s_n$) according to a truncated polynomial Volterra's which approximates said predistortion function.

12. The system of claim 11, **characterized in that** said control signal includes updated coefficients ($\{c_{2i+1}\}_{i \neq 0}$) of odd predistortion terms of Volterra's series.

13. The system of claim 11, **characterized in that** said control signal includes the only algebraic signs of complex coefficient increments of odd predistortion terms of Volterra's series, averaged for a predetermined time period depending on symbol interval ($T_s$).

**14.** The system of claim 13, **characterized in that** said predistorting means (53) are configured to receive said algebraic signs and updating the corresponding complex coefficients by means of the following expression:

$$c_{2i+1}(n+1) = c_{2i+1}(n) - \alpha\left(algebraic\ received\ sign\right),$$

where

- $c_{2i+1}(n+1)$ are the updated coefficients $c_i$ at the $n^{th}+1$ updating interval, and
- $\alpha$ is a predetermined numerical factor acting on the convergence speed of coefficient updating.

**Patentansprüche**

**1.** Verfahren zum Kompensieren von Signalverzerrung, die durch einen verzerrenden Hochfrequenz-Leistungsverstärker (54) in einem Sender (TX) erzeugt wird, der mit einem entfernten Empfänger (RX) verbunden ist, wobei das Verfahren die folgenden Schritte umfasst:

- Vorverzerren (53) eines linear modulierten Übertragungssignals ($s_n$), bevor es den verzerrenden Verstärker (54) durchläuft, gemäß einer Vorverzerrungsfunktion, die durch eine abgebrochene polynomische Volterrareihe des Übertragungssignals approximiert wird;
- Erzeugen eines Vorverzerrungs-Steuersignals ($\{c_{2i+1}\}_{i\neq0}$) aus der Berechnung eines Fehlers der Funktion der Restverzerrung ($\varepsilon_n$) einer Schätzung von übertragenen Informationssymbolen ($\hat{a}_n$) durch den Empfänger (RX);
- Zurückübertragen des Vorverzerrungs-Steuersignals durch den Empfänger (RX) zu dem Sender (TX);
- Empfangen des Vorverzerrungs-Steuersignals in dem Sender (TX) und Verwenden dieses zum Aktualisieren (53) der ungeraden Terme der polynomischen Volterrareihe,
**dadurch gekennzeichnet, dass**
- der Fehler der Restverzerrung ($\varepsilon_n$) durch Subtrahieren der Schätzung ($\hat{a}_n$) von dem im Empfänger empfangenen Basisband-Empfangssignal ($u(nT_s)$) berechnet wird, nachdem es Folgendem unterzogen wird: Filterung (56), Entzerrung und sowohl Symbol- als auch Trägersynchronisations-Wiederherstellung.

**2.** Verfahren nach Anspruch 1, **dadurch gekennzeichnet, dass** dem Vorverzerrungsschritt (53) eine Aufwärtsabtastung (52) des Übertragungssignals durch ein Vielfaches der Symbolrate nahezu gleich der maximalen Ordnung des letzten Terms in der abgebrochenen Volterrareihe vorausgeht.

**3.** Verfahren nach Anspruch 2, **dadurch gekennzeichnet, dass** das Empfangssignal auf Symbolrate abwärts abgetastet wird (57).

**4.** Verfahren nach einem der Ansprüche von 1 bis 3, **dadurch gekennzeichnet, dass** das Aktualisierungsintervall der Vorverzerrungsfunktion eine vorbestimmte Anzahl von Symbolintervallen überspannt.

**5.** Verfahren nach einem der Ansprüche von 1 oder 4, **dadurch gekennzeichnet, dass** das an den Sender zurückgegebene Steuersignal die komplexen Koeffizienten ($\{c_{2i+1}\}_{i\neq0}$) ungerader Vorverzerrungsterme der Volterrareihe durch den folgenden Ausdruck aktualisiert umfasst:

$$c_{2i+1}(n+1) = c_{2i+1}(n) - \alpha\varepsilon_n\left|\hat{a}_n\right|^{2i}\hat{a}_n^*$$

für $1 \leq i \leq M$ und $c_{2i+1}(0)=0$, wobei

- $c_{2i+1}(n+1)$ die aktualisierten Koeffizienten $c_i$ im (n+1)-ten Aktualisierungsintervall sind,
- $\varepsilon_n$ der Fehler der Restverzerrung ist,
- $\alpha$ ein an der Konvergenzgeschwindigkeit der Koeffizientenaktualisierung wirkender vorbestimmter numerischer Faktor ist,

- $\hat{a}_n$ die Schätzung des in dem Symbolintervall $nT_s$ übertragenen Informationssymbols ist und der Stern komplex-konjugiert bedeutet.

**6.** Verfahren nach einem der Ansprüche von 1 bis 5, **dadurch gekennzeichnet, dass** der Fehler der Restverzerrung ($\varepsilon_n$) durch den folgenden Ausdruck berechnet wird:

$$\varepsilon_n = u\left(nT_s\right) - \hat{a}_n \, ,$$

wobei

- $\varepsilon_n$ der im n-ten Symbolintervall $T_s$ berechnete Fehler der Restverzerrung ist,
- $u(nT_s)$ das Empfangssignal ist, nachdem es Folgendem unterzogen wird: Filterung, Entzerrung und sowohl Symbolals auch Trägersynchronisations-Wiederherstellung;
- $\hat{a}_n$ die Schätzung des zum Zeitpunkt $nT_s$ übertragenen Informationssymbols ist.

**7.** Verfahren nach Anspruch 1, **dadurch gekennzeichnet, dass** das an den Sender (TX) zurückgegebene Steuersignal die einzigen algebraischen Vorzeichen komplexer Koeffizienteninkremente ungerader Vorverzerrungsterme der Volterrareihe auf einen vorbestimmten Zeitraum abhängig von dem Symbolintervall ($T_s$) gemittelt umfasst.

**8.** Verfahren nach Anspruch 7, **dadurch gekennzeichnet, dass** der Sender (TX) beim Empfang der algebraischen Vorzeichen die entsprechenden komplexen Koeffizienten mittels des folgenden Ausdrucks aktualisiert:

$$c_{2i+1}\left(n+1\right) = c_{2i+1}\left(n\right) - \alpha$$

(algebraisches empfangenes Vorzeichen), wobei

- $c_{2i+1}(n+1)$ die aktualisierten Koeffizienten $c_1$ im (n+1)-ten Aktualisierungsintervall sind und
- $\alpha$ ein an der Konvergenzgeschwindigkeit der Koeffizientenaktualisierung wirkender vorbestimmter numerischer Faktor ist.

**9.** Verfahren nach einem der Ansprüche von 1 bis 8, **dadurch gekennzeichnet, dass** die aktualisierten Terme der polynomischen Volterrareihe die einzigen dritten und fünften sind.

**10.** System zum Kompensieren der Signalverzerrung, die durch einen verzerrenden Hochfrequenz-Leistungsverstärker (54) in einem Sender (TX) erzeugt wird, der mit einem entfernten Empfänger (RX) verbunden ist, wobei der Sender ferner Folgendes umfasst:

- Vorverzerrungsmittel (53), die auf ein Vorverzerrungs-Steuersignal ($\{c_{2i+1}\}_{i\neq0}$) reagieren, um eine Vorverzerrungsfunktion zu aktualisieren, die den Verzerrungen entgegenwirkt, die an dem Übertragungssignal durch den signalabwärts verbundenen verzerrenden Verstärker (54) eingeführt werden;
- Mittel zum Empfangen des Vorverzerrungs-Steuersignals auf einem Rückwärtskanal (RL);

und der Empfänger Folgendes umfasst:

- Verarbeitungsmittel, die dafür programmiert sind, das Empfangssignal zu filtern (56) und zu entzerren und sowohl Symbol- als auch Übertragungsträger-Synchronisationen wiederherzustellen;
- Mittel (58) zum Schätzen von übertragenen Informationssymbolen ($\hat{a}_n$) aus dem Basisband-Empfangssignal, das im Empfänger empfangen wird;
- Mittel (59, 60, 61, 62) zum Erzeugen des Vorverzerrungs-Steuersignals aus der Berechnung eines Fehlers der Funktion der Restverzerrung ($\varepsilon_n$) der Schätzung ($\hat{a}_n$) von übertragenen Informationssignalen;
- Mittel (RL) zum Übertragen des Vorverzerrungs-Steuersignals auf einem Rückwärtskanal (RL) zwischen dem Empfänger und dem Sender;
**dadurch gekennzeichnet, dass**
- die Mittel zum Erzeugen des Vorverzerrungs-Steuersignals dafür ausgelegt sind, den Fehler der Restverzer-

rung ($\varepsilon_n$) durch Subtrahieren der Schätzung ($\hat{a}_n$) von dem Basisband-Empfangssignal ($u(nT_s)$), nachdem es durch die digitalen Verarbeitungsmittel verarbeitet wird, zu berechnen.

11. System nach Anspruch 10, **dadurch gekennzeichnet, dass** die Vorverzerrungsmittel (53) dafür ausgelegt sind, das Übertragungssignal ($s_n$) gemäß einer abgebrochenen polynomischen Volterrareihe, die die Vorverzerrungsfunktion approximiert, vorzuverzerren.

12. System nach Anspruch 11, **dadurch gekennzeichnet, dass** das Steuersignal aktualisierte Koeffizienten ($\{c_{2i+1}\}_{i\neq0}$) ungerader Vorverzerrungsterme der Volterrareihe umfasst.

13. System nach Anspruch 11, **dadurch gekennzeichnet, dass** das Steuersignal die einzigen algebraischen Vorzeichen komplexer Koeffizienteninkremente ungerader Vorverzerrungsterme der Volterrareihe für einen vorbestimmten Zeitraum abhängig von dem Symbolintervall ($T_s$) gemittelt umfasst.

14. System nach Anspruch 13, **dadurch gekennzeichnet, dass** die Vorverzerrungsmittel (53) dafür ausgelegt sind, die algebraischen Vorzeichen zu empfangen und die entsprechenden komplexen Koeffizienten mittels des folgenden Ausdrucks zu aktualisieren:

$$c_{2i+1}(n+1) = c_{2i+1}(n) - \alpha$$

(algebraisches empfangenes Vorzeichen), wobei

- $c_{2i+1}(n+1)$ die aktualisierten Koeffizienten $c_i$ im ($n+1$)-ten Aktualisierungsintervall sind und
- $\alpha$ ein an der Konvergenzgeschwindigkeit der Koeffizientenaktualisierung wirkender vorbestimmter numerischer Faktor ist.

**Revendications**

1. Un procédé de compensation d'une distorsion de signal générée par un amplificateur de puissance radiofréquence de distorsion (54) dans un émetteur (TX) relié à un récepteur distant (RX), le procédé comprenant les opérations suivantes :

- la prédistorsion (53) d'un signal de transmission modulé linéairement ($s_n$) avant qu'il ne traverse ledit amplificateur de distorsion (54) selon une fonction de prédistorsion approximée par une série de Volterra polynomiale tronquée dudit signal de transmission,
- la génération par le récepteur (RX) d'un signal de commande de prédistorsion ($\{c_{2i+1}\}_{i?0}$) à partir du calcul d'une erreur de fonction de distorsion résiduelle ($\varepsilon_n$) d'une estimation de symboles d'information transmis ($\hat{a}_n$),
- la transmission par le récepteur (RX) dudit signal de commande de prédistorsion en retour à l'émetteur (TX),
- la réception sur l'émetteur (TX) dudit signal de commande de prédistorsion et son utilisation pour actualiser (53) les termes impairs de la série de Volterra polynomiale,

**caractérisé en ce que** :

- ladite erreur de distorsion résiduelle ($\varepsilon_n$) est calculée en soustrayant ladite estimation ($\hat{a}_n$) du signal de réception de bande de base ($u(nT_s)$) reçu sur le récepteur après avoir été soumis aux opérations suivantes : filtrage (56), égalisation et récupération de la synchronisation de la porteuse et du symbole.

2. Le procédé selon la revendication 1, **caractérisé en ce que** ladite opération de prédistorsion (53) est précédée par un sur-échantillonnage (52) dudit signal de transmission par un multiple du débit de symboles quasiment égal à l'ordre maximum du dernier terme de ladite série de Volterra tronquée.

3. Le procédé selon la revendication 2, **caractérisé en ce que** ledit signal de réception est sous-échantillonné (57) vers le débit de symboles.

4. Le procédé selon l'une quelconque des revendications 1 à 3, **caractérisé en ce que** l'intervalle d'actualisation de la fonction de prédistorsion couvre un nombre prédéterminé d'intervalles de symboles.

**5.** Le procédé selon l'une quelconque des revendications 1 ou 4, **caractérisé en ce que** ledit signal de commande renvoyé à l'émetteur contient les coefficients complexes ($\{c_{2i+1}\}_{i?0}$) de termes de prédistorsion impairs de la série de Volterra actualisés par l'expression suivants :

$$c_{2i+1}(n+1) = c_{2i+1}(n) - \alpha\varepsilon_n \left|\hat{a}_n\right|^{2i} \hat{a}_n^*,$$

pour $1 = i = M$ et $c_{2i+1}(0) = 0$, où :

- $c_{2i+1}(n+1)$ sont les coefficients actualisés $c_i$ au $n^{ième} + 1$ intervalle d'actualisation,

- $\varepsilon_n$ est ladite erreur de distorsion résiduelle,
- $á$ est un facteur numérique prédéterminé agissant sur la vitesse de convergence de l'actualisation de coefficient,
- $a^\wedge_n$ est l'estimation du symbole d'information transmis à l'intervalle de symbole $nT_s$ et l'astérisque dénote conjugué complexe.

**6.** Le procédé selon l'une quelconque des revendications 1 à 5, **caractérisé en ce que** ladite erreur de distorsion résiduelle ($\varepsilon_n$) est calculée par l'expression suivante :

$$\varepsilon_n = (u(nT_s) - \hat{a}_n,$$

où :

- $\varepsilon_n$ est ladite erreur de distorsion résiduelle calculée au $n^{ième}$ intervalle de symboles $T_s$,
- $u(nT_s)$ est le signal de réception après avoir été soumis aux opérations suivantes : filtrage, égalisation et récupération de la synchronisation de la porteuse et du symbole,
- $a^\wedge_n$ est l'estimation de symbole d'information transmis à l'instant $nT_s$.

**7.** Le procédé selon la revendication 1, **caractérisé en ce que** ledit signal de commande renvoyé à l'émetteur (TX) contient les seuls signes algébriques d'incréments de coefficient complexe de termes de prédistorsion impairs de la série de Volterra, moyennés sur une durée prédéterminée dépendant de l'intervalle de symboles ($T_s$).

**8.** Le procédé selon la revendication 7, **caractérisé en ce que** l'émetteur (TX), après réception desdits signes algébriques, actualise les coefficients complexes correspondants au moyen de l'expression suivante :

$$c_{2i+1}(n+1) = c_{2i+1}(n) - á \ (signe \ algébrique \ reçu),$$

où

- $c_{2i+1}(n+1)$ sont les coefficients actualisés $c_i$ au $n^{ième} + 1$ intervalle d'actualisation, et
- $á$ est un facteur numérique prédéterminé agissant sur la vitesse de convergence de l'actualisation de coefficient.

**9.** Le procédé selon l'une quelconque des revendications 1 à 8, **caractérisé en ce que** lesdits termes actualisés de la série de Volterra polynomiale ne sont que les troisième et cinquième.

**10.** Un système de compensation de la distorsion de signal générée par un amplificateur de puissance radiofréquence de distorsion (54) dans un émetteur (TX) relié à un récepteur distant (RX), l'émetteur comprenant en outre :

- un moyen de prédistorsion (53) réactif à un signal de commande de prédistorsion ($\{c_{2i+1}\}_{i?0}$) pour actualiser une fonction de prédistorsion contrecarrant les distorsions introduites dans le signal de transmission par ledit amplificateur de distorsion (54) raccordé en aval,

- un moyen de réception dudit signal de commande de prédistorsion sur un canal inverse (RL) le récepteur comprenant :
- un moyen de traitement programmé pour filtrer (56) et égaliser le signal de réception et pour récupérer les synchronisations de la porteuse de transmission et du symbole,
- un moyen (58) d'estimation de symboles d'information transmis ($\hat{a}_n$) du signal de réception de bande de base reçu dans le récepteur,
- un moyen (59, 60, 61, 62) de génération dudit signal de commande de prédistorsion à partir du calcul d'une erreur d'une fonction de distorsion résiduelle ($\varepsilon_n$) de l'estimation ($\hat{a}_n$) de signaux d'informations transmis,
- un moyen (RL) de transmission dudit signal de commande de prédistorsion sur un canal inverse (RL) entre ledit récepteur et ledit émetteur,

**caractérisé en ce que** :

- ledit moyen de génération du signal de commande de prédistorsion est configuré de façon à calculer l'erreur de distorsion résiduelle ($\varepsilon_n$) en soustrayant ladite estimation ($\hat{a}_n$) du signal de réception de bande de base ($u(nT_s)$) après avoir été traité par ledit moyen de traitement numérique.

**11.** Le système selon la revendication 10, **caractérisé en ce que** ledit moyen de prédistorsion (53) est configuré de façon à prédistordre le signal de transmission ($s_n$) selon une série de Volterra polynomiale tronquée qui approxime ladite fonction de prédistorsion.

**12.** Le système selon la revendication 11, **caractérisé en ce que** ledit signal de commande contient des coefficients actualisés ($\{c_{2i+1}\}_{i?0}$) de termes de prédistorsion impairs de la série de Volterra.

**13.** Le système selon la revendication 11, **caractérisé en ce que** ledit signal de commande contient les seuls signes algébriques d'incréments de coefficient complexe de termes de prédistorsion impairs de la série de Volterra moyennés pendant une durée prédéterminée dépendant de l'intervalle de symboles ($T_s$).

**14.** Le système selon la revendication 13, **caractérisé en ce que** ledit moyen de prédistorsion (53) est configuré de façon à recevoir lesdits signes algébriques et à actualiser les coefficients complexes correspondants au moyen de l'expression suivante :

$$c_{2i+1}(n+1) = c_{2i+1}(n) - á(signe\ algébrique\ reçu),$$

où

- $c_{2i+1}(n+1)$ sont les coefficients actualisés $c_i$ au $n^{ième}$ + 1 intervalle d'actualisation, et
- á est un facteur numérique prédéterminé agissant sur la vitesse de convergence de l'actualisation de coefficient.

BPNL

x(t)

HPA

$$\sum_p a_p \left[ x(t) \right]^p$$

$\omega_0$

y(t)

FIG.1

REAL BAND-PASS SIGNAL

$X(\omega)$

$-\omega_0$    $0$    $\omega_0$    $\omega$

ANALYTIC BAND-PASS SIGNAL

$\mathring{X}(\omega)$

$0$    $\omega_0$    $\omega$

EQUIVALENT LOW-PASS SIGNAL

$\tilde{X}(\omega)$

$0$    $\omega$

FIG.2

# KNOWN ART

FIG.3

# KNOWN ART

FIG.4

FIG.5

FIG.6

FIG.7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1280272 B1
- WO 9828888 A

- US 5910965 A1

**Non-patent literature cited in the description**

- **G. Lazzarin ; S. Pupolin.** Nonlinearity compensation in digital radio systems. *IEEE Transactions on Communications,* February 1994, vol. 42 (2/3/4

- **S. Benedetto ; E. Biglieri ; V. Castellani.** Digital Transmission Theory. Prentice-Hall, 1987
- **John G. Proakis.** Digital Communications. Mc-Graw-Hill, 2001